# EUROPEAN PATENT APPLICATION

(11) **EP 2 851 960 A1**
(43) Date of publication of application: **25.03.2015**
(21) Application number: 14185106.3
(22) Date of filing: 17.09.2014
(51) Int. Cl.: H01L 31/0224, H01L 31/0328, H01L 31/0352, H01L 31/0745, H01L 31/078

(54) **Photoelectric conversion element**

(30) Priority: 20.09.2013 JP 2013196105
(71) Applicant: Kabushiki Kaisha Toshiba, Tokyo 105-8001 (JP)
(72) Inventor: Fujimoto, Akira, Tokyo, 105-8001 (JP); Nakanishi, Tsutomu, Tokyo, 105-8001 (JP); Nakamura, Kenji, Tokyo, 105-8001 (JP)
(74) Representative: Hoffmann Eitle

(57) **Abstract**

The present disclosure provides a photoelectric conversion element comprising a photoelectric conversion layer laminated a first metal layer, a first semiconductor layer, a second semiconductor layer and a second metal layer. The first or second metal layer contains a porous metal thin film, and the porous metal thin film has plural openings penetrating through the film. Each of the openings has an area of 80 nm² to 0.8 µm² inclusive on average, and the porous metal thin film has a thickness of 2 nm to 200 nm inclusive. The second semiconductor layer has a smaller band gap than the first semiconductor layer, has polarity opposite to that of the first semiconductor layer, and is positioned within 5 nm from the porous metal thin film.

## Description

### FIELD

Embodiments of the present disclosure relate to photoelectric conversion elements.

### BACKGROUND

An ordinary photoelectric conversion element, which employs a semiconductor, has an absorption wavelength band depending on the band gap of the semiconductor and hence cannot sufficiently absorb the energy of solar spectrum. For example, since absorbing light only in the range of 300 to 1100 nm, a single crystal Si solar cell has a generation efficiency of only slightly more than 20%. Accordingly, in order to improve the generation efficiency of a normal photoelectric conversion element, it is necessary to form such an area in a photoelectric conversion layer as absorbs light in a longer wavelength range where the conversion layer by itself cannot absorb the energy.

Meanwhile, as a means for improving the efficiency of a photoelectric conversion element, a method is proposed in which plasmon resonance is caused by use of a metal nano-structure to generate enhanced electric fields and thereby to propagate carrier excitation.

In a process hitherto adopted, the back surface of a semiconductor substrate is subjected to doping treatment to form a long wavelength-absorbing region in the band gap of the semiconductor and then a metal mesh is provided thereon so as to collect photovoltaic currents generated by absorption in the long wavelength range and thereby to improve the photoelectric conversion efficiency of solar cell.

However, since the long wavelength-absorbing layer is formed by doping, there is a problem in that the doping concentration is insufficient and accordingly the absorption rate is unsatisfactory even if the absorption arises from direct transitions.

### BRIEF DESCRIPTION OF THE DRAWINGS

Figure 1 is a spectrum of sunlight (AM1.5) absorbed by a conventional photoelectric conversion element.
Figure 2 is a graph showing spectral sensitivity characteristics of a conventional photoelectric conversion element serving as a single crystal Si solar cell.
Figure 3 is a spectrum of sunlight absorbed by a photoelectric conversion element of the embodiment.
Figures 4A and 4B schematically illustrate the structure of a conventional photoelectric conversion element.
Figures 5A to 5C schematically illustrate the structure of a photoelectric conversion element comprising a long wavelength-absorbing layer and a nano-mesh electrode according to the embodiment.
Figures 6A and 6B schematically illustrate behavior of free electrons when a metal nano-structure is exposed to light.
Figures 7A and 7B show conceptual sketches of a nano-mesh electrode and metal dots.
Figures 8A and 8B schematically illustrate a metal nano-structure.
Figure 9 is a graph showing correlation between the mesh interval of a nano-mesh electrode and enhancement of electric fields.
Figure 10 is a graph showing correlation between the radius of metal dot and expansion of local electric field.
Figures 11A to 11C show schematic sectional views illustrating a method of producing a photoelectric conversion element according to the embodiment.
Figures 12A to 12E show schematic sectional views illustrating a method of producing a photoelectric conversion element according to the embodiment.
Figures 13A to 13D show schematic sectional views illustrating a method of producing a photoelectric conversion element according to the embodiment.

### DETAILED DESCRIPTION

Embodiments will now be explained with reference to the accompanying drawings.

A photoelectric conversion element according to the embodiment comprises a photoelectric conversion layer laminated a first metal layer, a first semiconductor layer, a second semiconductor layer and a second metal layer; wherein
said first or second metal layer contains a porous metal thin film,
said porous metal thin film has plural openings penetrating through said porous metal thin film,
each of said openings has an area of 80 nm² to 0.8 µm² inclusive on average,
said porous metal thin film has a thickness of 2 nm to 200 nm inclusive,
said second semiconductor layer has a smaller band gap than said first semiconductor layer,
said second semiconductor layer has polarity opposite to that of said first semiconductor layer, and
said second semiconductor layer is positioned within 5 nm from said porous metal thin film.

Another photoelectric conversion element according to the embodiment comprises a photoelectric conversion layer laminated a first metal layer, a first semiconductor layer, a second semiconductor layer and a second metal layer; wherein
a layer containing plural minute metal particles is provided on said semiconductor layers,
each of said minute particles has a volume of 4 nm³ to 0.52 µm³ inclusive on average,
the interval between adjacent two of said minute particles is 1 nm or more if the particle volume is less than 4 x 10⁻³ µm³, but is 100 nm to 1 µm inclusive if the particle volume is 4 x 10⁻³ µm³ or more,
said second semiconductor layer has a smaller band gap than said first semiconductor layer,
said second semiconductor layer has polarity opposite to that of said first semiconductor layer, and
said second semiconductor layer is positioned within 5 nm from said minute particles.

The embodiments will be described below with reference to the attached drawings.

Photoelectric conversion elements according to the embodiments are explained below by referring to the drawings, in which the same or similar parts are identified by the same or similar numbers, respectively.

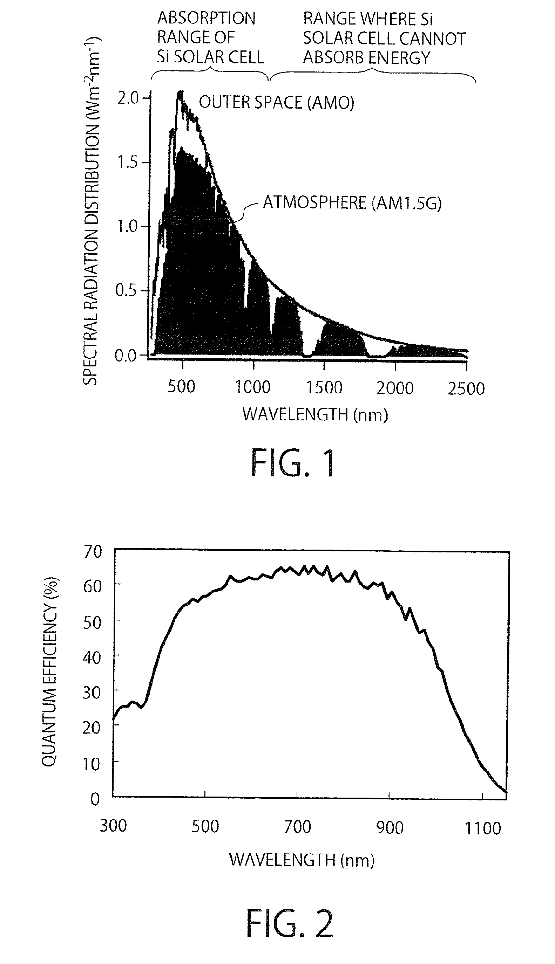

First, it is explained in principle by referring to Figures 1 and 2 how light of long wavelength is absorbed by a semiconductor layer having a smaller band gap than the photoelectric conversion layer of the element according to the embodiment. Figure 1 is a spectrum of sunlight (AM1.5) absorbed by a conventional photoelectric conversion element, and Figure 2 is a graph showing spectral sensitivity characteristics of the conventional element serving as a single crystal Si solar cell. In Figure 1, the wavelength of light and the spectral radiation distribution are plotted on the horizontal and vertical axes, respectively. On the other hand, the wavelength of light and the quantum efficiency are plotted on the horizontal and vertical axes, respectively, in Figure 2.

As shown in Figure 1, since the spectrum of sunlight is based on the black-body radiation of the sun, the radiated light widely ranges from 300 nm to 2500 nm.

However, as shown in Figure 2, since the light absorption spectrum of single crystal Si depends on its band gap 1.12 eV, the single crystal Si can absorb light only in the range of 300 to 1100 nm. The conventional photoelectric conversion element, therefore, can gain only a part of the sunlight energy, and accordingly has a generation efficiency of about 20% at most.

In order for the photoelectric conversion element to absorb light in a longer wavelength range, it may be generally thought to be effective to adopt a semiconductor having a small band gap, such as Ge. However, if the band gap is smaller, the absorption light wavelength ranges wider but the open circuit voltage is lowered because of the low band gap. As a result, the generation efficiency in itself does not increase. On the contrary, the generation efficiency may decrease because of the low open circuit voltage.

Accordingly, the photoelectric conversion element needs to absorb light in a longer wavelength range while keeping a proper band gap (1 to 2 eV).

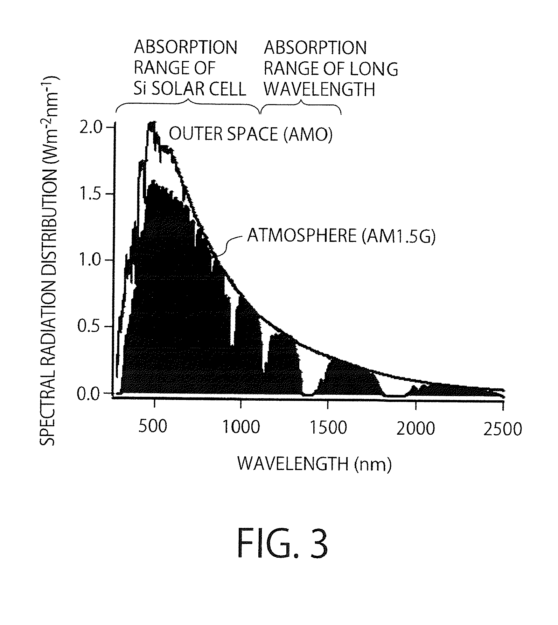

In view of that, the applicant has found that a photoelectric conversion element having a proper band gap (1 to 2 eV) can be made to absorb light in a longer wavelength range, as shown in Figure 3, by introducing a semiconductor layer having a smaller band gap than the photoelectric conversion element by itself.

However, if the semiconductor layer having a small band gap is provided on a photoelectric conversion layer, an energy barrier is generally caused because of band discontinuity. Accordingly, even if light generates carriers in the semiconductor layer, there is a problem in that the carriers cannot be injected into the photoelectric conversion layer.

For avoiding that problem, a tunnel junction is formed between the conversion layer and the semiconductor layer serving as a long wavelength-absorbing layer, so that the carriers can flow through the barrier by the tunnel effect into the conversion layer.

Further, in order that the carriers generated in the semiconductor layer may flow into the conversion layer, the distribution of the photo-generated carriers must be inclined from the semiconductor layer-side to the conversion layer-side. Actually, however, the distribution is normally inclined from the conversion layer-side to the semiconductor layer-side and therefore the carriers cannot flow into the conversion layer.

Accordingly, it is also necessary to provide a means for inclining the distribution of the carriers generated in the semiconductor layer from the semiconductor surface-side to the conversion layer-side.

In view of that, the applicant has found a composition in which plasmon resonance is caused by use of a metal nano-structure to generate enhanced electric fields and thereby to propagate carrier excitation, which induces electric fields enhanced several times to several hundred times as strong as normal ones within tens of nanometers depth just under the metal nano-structure, so that the carrier distribution is inclined from the semiconductor surface-side to the conversion layer-side by the action of the electric field-enhancement effect of the metal nano-structure. In the photoelectric conversion element, this constitution makes it possible to transfer light energy in the amount absorbed in the semiconductor layer into the photoelectric conversion layer.

Figure 3 is a spectrum of sunlight absorbed by a photoelectric conversion element of the embodiment.

As shown in Figure 3, if Ge is adopted as the small band gap-semiconductor incorporated in a conversion element employing Si (band gap: Eg = 1.12 eV), the light absorption range is prolonged to as long a wavelength as 1600 nm. That is because Ge has a band gap Eg of 0.67 eV.

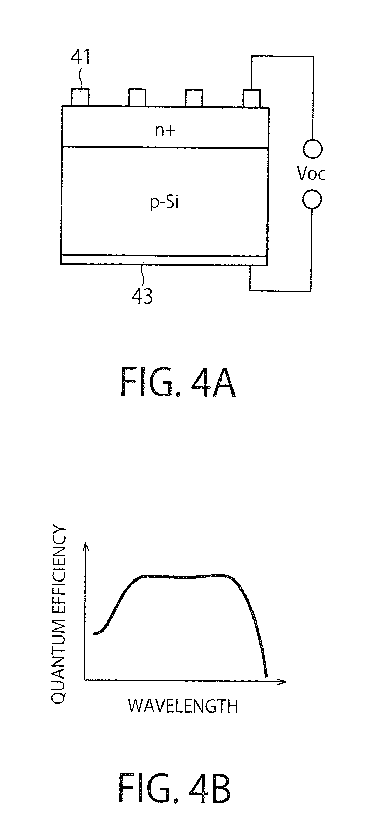

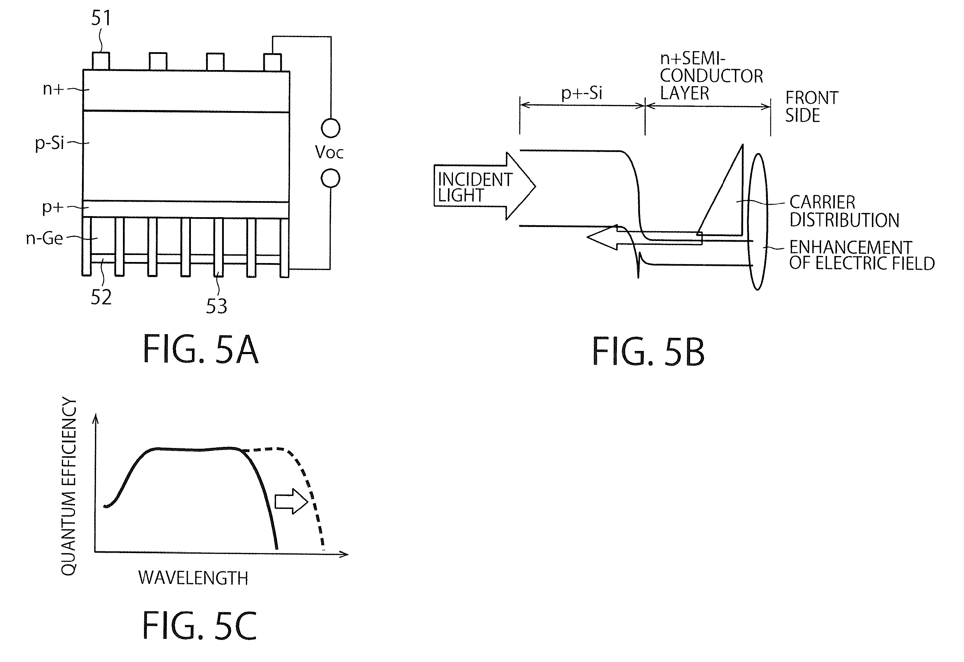

In the following description, the constitution of the photoelectric conversion element according to the embodiment is explained by referring to Figures 4 and 5. Figure 4A schematically illustrates the structure of a conventional photoelectric conversion element, and Figure 4B is a graph showing correlation between the light wavelength and the quantum efficiency in the conventional conversion element. Further, Figure 5A schematically illustrates the structure of a photoelectric conversion element having a long wavelength-absorbing layer according to the embodiment, Figure 5B is an energy band diagram showing a tunnel junction and carrier distribution in the structure comprising a photoelectric conversion layer, a long wavelength-absorbing layer and a nano-mesh electrode, and Figure 5C is a graph showing correlation between the light wavelength and the quantum efficiency in the conversion element having a long wavelength-absorbing layer according to the embodiment.

As shown in Figure 4A, in the conventional photoelectric conversion element, an n+ layer is laid on a P-Si layer and a front electrode 41 is provided on the n+ layer. Further, a back electrode 43 is provided on the back surface of the P-Si layer. When incident light comes into the P-Si layer in the conventional conversion element, electrons and holes are separated to the conduction band and the valence band in accordance with the band gap level and then are taken out in the form of photovoltaic currents to an external Voc.

However, if the incident light has a long wavelength, the conventional conversion element shows low quantum efficiency as shown in Figure 4B. Accordingly, when exposed to light of long wavelength, the conventional element cannot extract photovoltaic currents because of the low quantum efficiency.

As shown in Figure 5A, in the photoelectric conversion element comprising a long wavelength-absorbing layer and a nano-mesh electrode according to the embodiment, an n+ layer is laid on a P-Si layer and a front electrode 51 is provided on the n+ layer. Further, a back electrode 53 is provided on the back surface of the P-Si layer. Furthermore, an n-Ge layer having a smaller band gap than the photoelectric conversion layer is provided on the back surface of the P-Si layer but is not in contact with the back electrode. The n-Ge layer can be formed by, for example, CVD (chemical vapor deposition) on the back surface of the P-Si layer. In addition, a nano-mesh electrode 52 is provided among the back electrode and is in contact with the n-Ge layer. The nano-mesh electrode provides minute metal particles (objects) on the n-Ge layer.

As shown in Figure 5B, since p-Si and n-Ge are semiconductors having different band gaps, the band discontinuity causes an energy barrier at the interface between them. For canceling the energy barrier, a tunnel junction is formed. In order to form a tunnel junction, it is necessary to increase the carrier concentration in the semiconductor layers at the interface. Accordingly, the concentration near the interface is 10¹⁹ cm⁻³ or more. On the other hand, however, the upper limit of the carrier concentration is about 10²² cm⁻³ in the semiconductor layers. If the concentration is more than that (namely, 1 x 10²² cm⁻³ ~), the matrix semiconductor in itself changes in properties (such as, band gap). That is unfavorable.

In the conversion element comprising the long wavelength-absorbing layer and the nano-mesh electrode according to the embodiment, the n-Ge layer is not in contact with the back electrode and hence voltage can be obtained in accordance with the band gap, as shown in Figure 5C. In addition, the n-Ge layer expands the absorption range into a longer wavelength range (as shown by dotted line). Further, since the nano-mesh electrode is positioned on the n-Ge layer, the amount of light absorption is increased by the effect of enhanced electric fields and accordingly the quantum efficiency is improved as shown in Figure 5C (as shown by dotted fat line).

In the above, Ge is adopted as the small band gap-semiconductor. However, GeSn, GaAb, PbS, PbSe and InSb, for example, are also usable. If the layer of the semiconductor has a thickness of about 10 nm, it gives acceptable effect. If having a thickness of about 1000 nm, the layer can absorb light sufficiently.

The n-Ge layer must be positioned near the nano-mesh electrode. That is because the nano-mesh electrode generates enhanced electric fields in the area within tens of nanometers depth just under the nano-mesh electrode and hence the enhanced electric fields have peak intensities just under the nano-mesh electrode. Accordingly, for benefitting from the enhanced electric fields, the n-Ge layer is preferably positioned within 5 nm from the nano-mesh electrode.

Since the enhanced electric fields generated by the nano-mesh electrode extend within tens of nanometers depth just under the nano-mesh electrode and also since they have peak intensities just under the nano-mesh electrode, the n-Ge layer must have a thickness of at least 10 nm so as to benefit from the enhanced electric fields.

As described above, since comprising the n-Ge layer 5 and the nano-mesh electrode 6, the photoelectric conversion element of Figure 5A according to the embodiment is improved in generation efficiency, as compared with a conventional element.

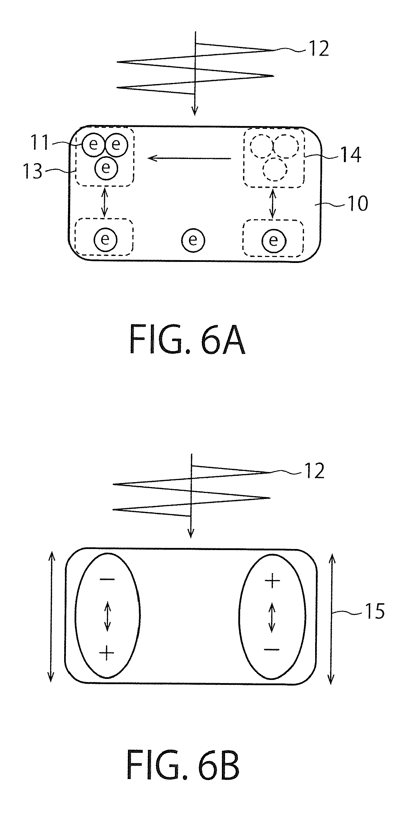

Next, it is explained in principle by referring to Figure 6 how a metal nano-structure causes plasmon resonance to generate enhanced electric fields. Figure 6A schematically illustrates behavior of free electrons when a metal nano-structure is exposed to light, and Figure 6B also schematically illustrates generation of local electric fields when the metal nano-structure is exposed to light.

As shown in Figure 6A, it is already known that, when the metal nano-structure 10 is exposed to light 12, surface plasmons are excited provided that the nano-structure 10 has a dimension equal to or smaller than the wavelength of the light 12. When the nano-structure 10 is exposed to light 13, free electrons 11 in the nano-structure 10 are induced to oscillate perpendicularly to the direction of light propagation. Consequently, on the upper side (side irradiated with the light 13) of the edges of the nano-structure 10, the oscillation of free electrons 11 causes areas 13 where the free electrons 11 are densely present and areas 14 where the free electrons 11 are thinly present.

Consequently, as shown in Figure 6B, local electric fields 15 that oscillate parallel to the direction of light propagation are generated near the edges of the nano-structure 10. The generated local electric fields 15 are several hundred times as strong as the electric fields generated by the light 12, and accordingly promote generation of electron-hole pairs.

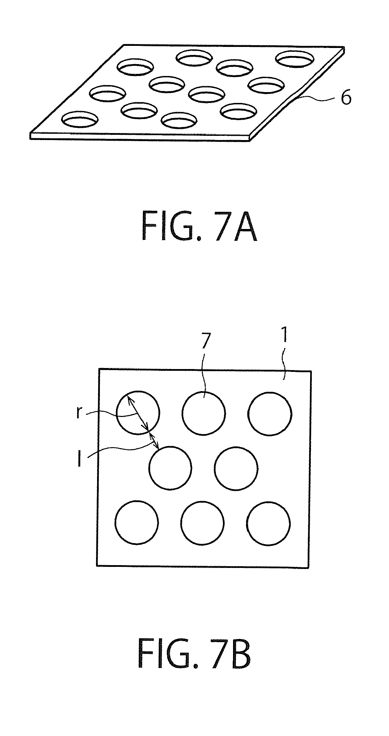

The structure of a nano-mesh electrode 6 (porous metal thin film) or a group of metal dots 7 (minute metal particles), which serves as the metal nano-structure, is explained below by referring to Figure 7. Figure 7A is a conceptual sketch of the nano-mesh electrode 6, and Figure 7B is a conceptual sketch of the metal dots 7.

The metal nano-structure may be, for example, a nano-mesh electrode 6 shown in Figure 7A. The nano-mesh electrode 6 has a porous structure, and is a continuous metal thin film provided with plural openings having sizes almost corresponding to the wavelength of incident light.

Otherwise, the metal nano-structure may be, for example, a group of metal dots 7 shown in Figure 7B. The metal dots 7 are formed on the p-Si layer 1 at intervals of I and each of them has a diameter r almost corresponding to the wavelength of incident light.

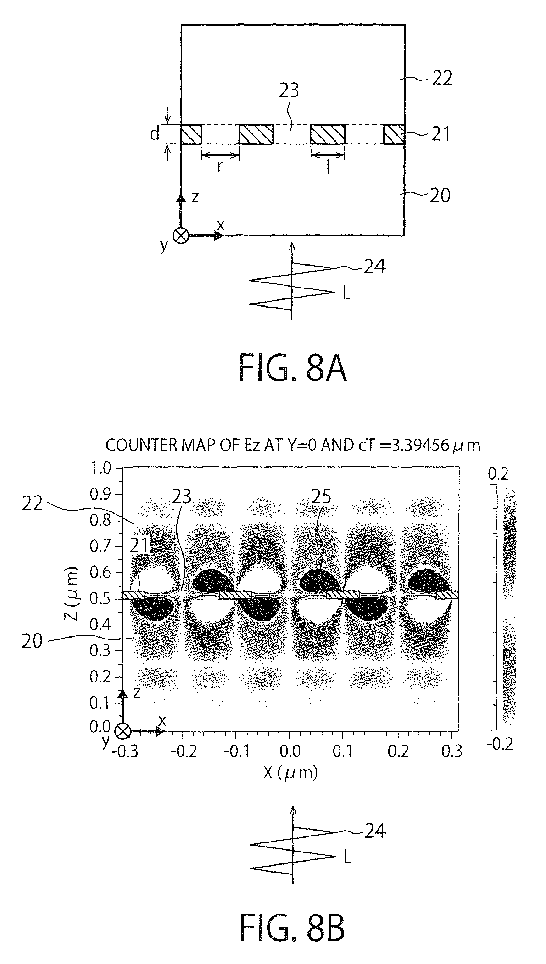

The strong local electric fields generated by the metal nano-structure are then explained below by referring to Figure 8.

Figure 8A schematically illustrates a metal nano-structure, and Figure 8B shows a result of simulation applied to the metal nano-structure according to the finite difference time domain (FDTD) method.

The structure subjected to the simulation comprises Si 20/Al 21/air 22, as shown in Figure 8A, and the Al 21 layer has a thickness of 30 nm. The Al 21 layer has openings 23 each of which has a diameter r of 100 nm and which are arranged at pitches l of 200 nm.

Electric field intensity in the structure of Figure 8A was simulated according to the finite difference time domain (FDTD) method under the assumption that the incident light 24 (λ=1000 nm, in the direction of light propagation) was applied to the structure. The result is shown in Figure 8B. The result of the simulation indicates that the electric fields are enhanced near the edges of Al 21 to generate local electric fields 25.

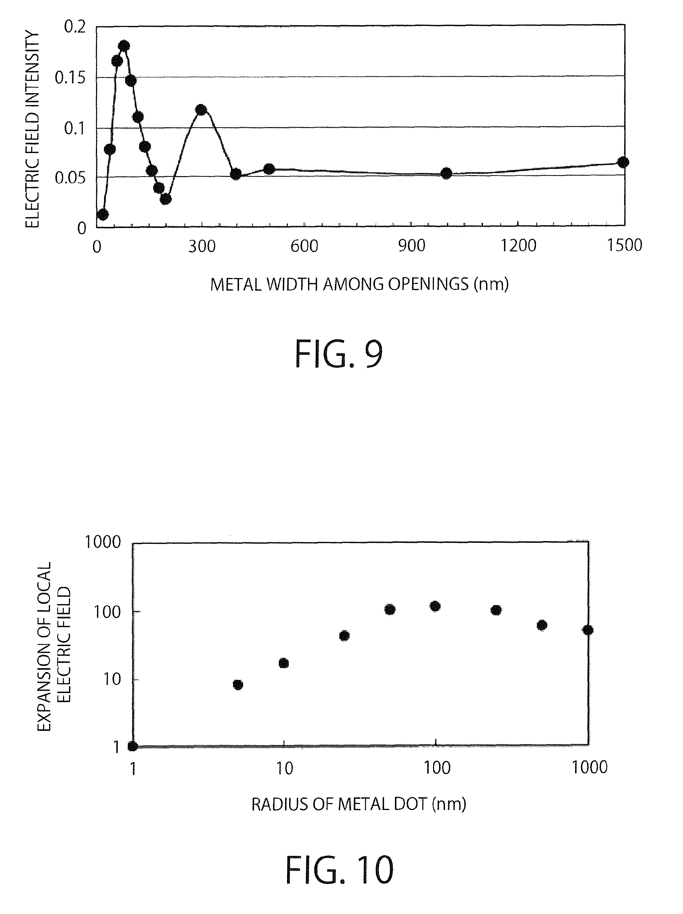

It is explained below by referring to Figure 9 how the enhancement of electric fields relates to the opening diameter of the nano-mesh electrode 6 serving as the metal nano-structure. Figure 9 is a graph showing correlation between the mesh interval of the nano-mesh electrode and the enhancement of electric fields. In Figure 9, the electric field intensity and the mesh interval are plotted on the vertical and horizontal axes, respectively.

As shown in Figure 9, in order to enhance the electric fields at the edges of Al 21, the openings 23 must be arranged at pitches r of 1 µm or less. This means that each opening 23 must have an area of 0.8 µm³ or less. On the other hand, in consideration of the processing preciseness, the opening pitches are about several tens of nanometers or more. This means that each opening 23 has an area of 80 nm³ or more.

Form the result of the above simulation, it is found that the enhanced electric fields can be sufficiently generated provided that the Al 21 layer has a thickness of 2 nm or more. However, if the Al 21 layer has a thickness of more than 200 nm, the enhancement is saturated.

With respect to the metal dots 7 serving as the metal nano-structure, the simulation was also carried out in the same manner as that for the nano-mesh electrode 6. Figure 10 is a graph showing correlation between the radius of the metal dot and expansion of local electric field. In Figure 10, the expansion of local electric field just under the metal dot and the radius of the metal dot are plotted on the vertical and horizontal axes, respectively.

The radius of the metal dot 7 ranges from 1 nm to 1000 nm in Figure 10. This range corresponds to 4 nm³ to 0.52 µm³ in terms of the volume of the dot 7 provided that the metal dots 7 are spheres. Accordingly, it is found that the electric field-enhancement effect can be sufficiently obtained if the metal dot 7 has a volume of 4 nm³ to 0.52 µm³ inclusive on average.

In the case where the radius is about 1000 nm or more, it is already known that energy transfer occurs among the metal dots 7 to weaken the electric field-enhancement effect if the intervals among the dots 7 are too narrow.

Also, as shown in Figure 10, if the metal dot 7 has a small dimension, the local electric field extends about half as widely as the dimension. For example, if the metal dot 7 has a radius of 1 nm (which corresponds to 4 nm³ in volume), the local electric field extends to 1 nm (which corresponds to the radius). However, the extension of the local electric field does not necessarily increase in accordance with increase of the dimension of the dot 7. If the dimension is larger than a particular value, the local electric field extends only in a range of about 100 nm or less. For example, if the metal dot 7 is a sphere having a radius of 100 nm or more (which corresponds to 4 x 10⁻³ µm³ or more in volume), the local electric field extends to about 100 nm or less.

As described above, in the case where the metal dot 7 has a volume of less than 4 x 10⁻³ µm³, energy transfer does not occur among the metal dots 7 if the interval between adjacent two of the dots 7 is 1 nm or more on average.

In the case where each metal dot 7 has a volume of 4 x 10⁻³ µm³ or more, energy transfer does not occur among the metal dots 7 if the interval between adjacent two of the dots 7 is 100 nm or more on average.

However, it is already known that, if the metal dots 7 are arranged in too large intervals, the dots 7 occupy such a small area as to weaken the electric field enhancement. The interval between adjacent two of the dots 7 is, therefore, 1 µm or less on average.

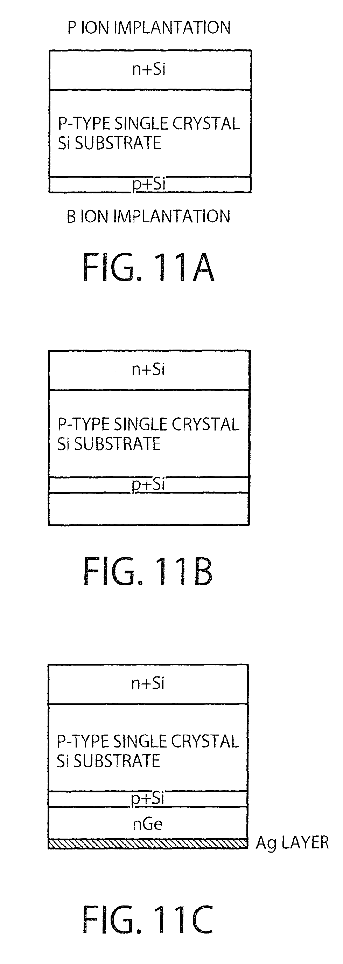

By referring to Figures 11 to 13, the following describes a method of producing a photoelectric conversion element according to the embodiment. Figures 11 to 13 show schematic sectional views illustrating a method of producing a photoelectric conversion element according to the embodiment.

In order to form a metal electrode pattern having openings of 200 to 300 nm or less, it is necessary to use state-of-the-art exposure apparatuses or electron beam lithographic systems, which are employed for producing semiconductor integrated circuits. However, if those apparatuses or systems are adopted, it is impossible to produce a large pattern at low cost. In contrast, nano-imprinting is known as a method capable of forming a large pattern at low cost. In the process explained below, nano-imprinting was, therefore, adopted to form a metal nano-mesh.

First, as shown in Figure 11A, a p-type single crystal Si substrate having a doping concentration of 1 x 10¹⁶ cm⁻³ was prepared. The front and back surfaces of the substrate were then subjected to ion implantation with P and B ions, respectively. After the ion implantation, activation annealing was carried out to form an n+ layer of 1 x 10²⁰ cm⁻³ concentration within 200 nm from the Si front surface and a P+ layer of 1 x 10²⁰ cm⁻³ concentration within 200 nm from the Si back surface.

Next, as shown in Figure 11B, an n-Ge layer of 1-µm thickness was formed according to the CVD method. During the formation of the layer, the doping concentration was so controlled that the concentration might be 10¹⁹ cm⁻³ within 100 nm from the interface with the Si surface but might be 10¹⁷ cm⁻³ in the farther range.

Subsequently, as shown in Figure 11C, Ag was vapor-deposited on the n-Ge surface to form an Ag layer of 30-nm thickness.

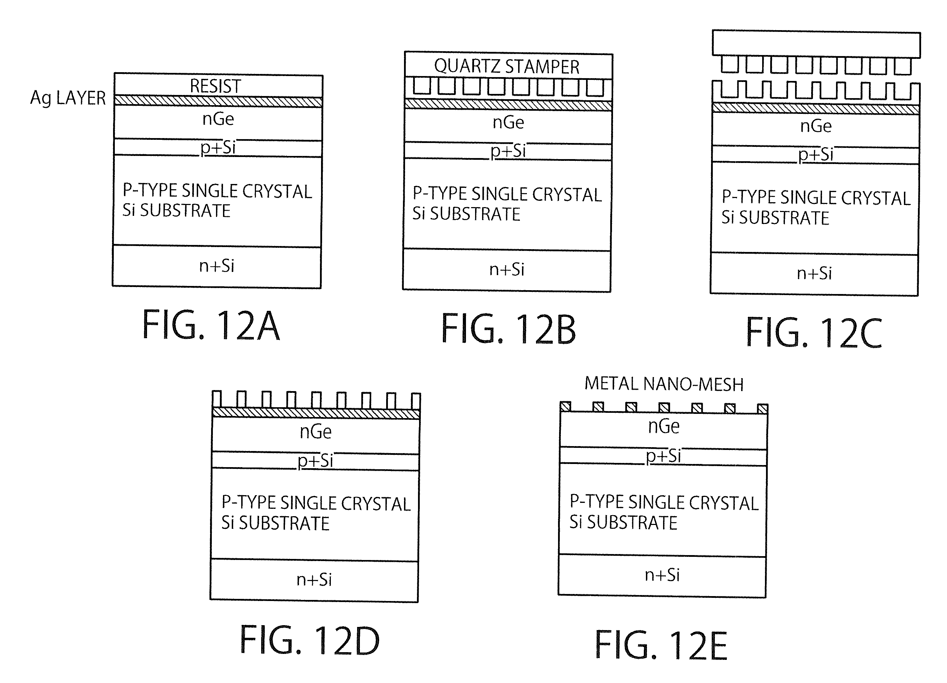

Then, as shown in Figure 12A, a resist was spread on the Ag layer formed on the n-Ge surface.

Thereafter, as shown in Figure 12B, a quartz stamper provided with a relief pattern of 200-nm size (the pattern was formed in an area of 9 cm²) was prepared and used to conduct imprinting procedure in which, while the p-type single crystal Si substrate was being heated, the relief surface of the stamper was impressed onto the resist.

After the imprinting procedure, the substrate was cooled and then the stamper 7 was released to form an intaglio pattern of 200-nm size on the resist layer, as shown in Figure 12C.

Subsequently, the intaglio pattern of the resist was subjected to reactive ion etching (RIE) with CF₄ to remove the bottom of the resist, as shown in Figure 12D.

After the bottom was removed, the Ag layer was etched by ion-milling, as shown in Figure 12E. The resist left on the etched Ag layer was then removed to form openings in the Ag layer. Thus, a metal nano-mesh was formed.

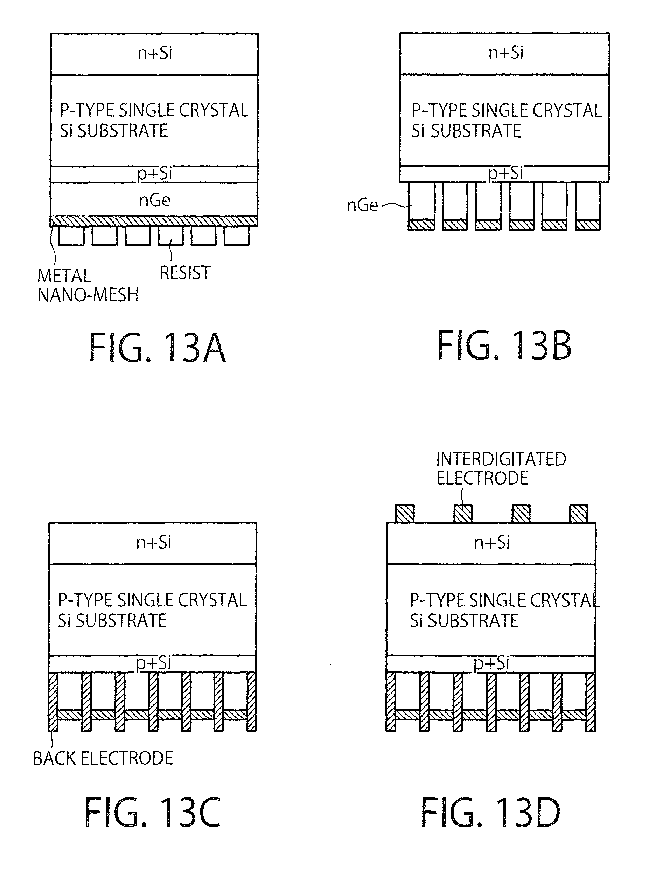

Further, as shown in Figure 13A, a resist was spread on the metal nano-mesh, subjected to photolithographic exposure through a grid pattern mask of 100-µm width and 1-mm interval, and then developed to form a resist pattern.

The formed resist pattern was used as a mask to etch the metal nano-mesh 8 by ion-milling, and thereafter the Ge layer was subjected to RIE with CF₄ to bare partly the p+Si layer, as shown in Figure 13B. The residual resist was then removed.

On the bared part of the p+Si layer, a back electrode was formed by the lift-off method, as shown in Figure 13C.

Finally, as shown in Figure 13D, an interdigitated electrode was formed on the n+ layer to obtain a photoelectric conversion element.

Although the above explanation was given for a single crystal Si photoelectric conversion element, a small band gap-semiconductor layer and a metal nano-mesh provided thereon can be also formed in other types of conversion elements, such as, polycrystal Si, amorphous Si and compound semiconductor elements, in manners similar to the above. Examples of the compound semiconductor include GaAs, CdTe and CIS.

### Examples

The following examples will further explain photoelectric conversion elements according to the embodiments in detail. The conversion elements were produced in a size of 9 cm², and the characteristics thereof were evaluated. In the examples, metal nano-meshes and metal dots were formed by nano-imprinting. However, they can be also formed by other methods (such as, a method utilizing self-assembling).

Examples 1 to 12 were summarized in a table, here.

**Table 1**

| | P-type substrate | Semiconductor | Electrode material | Electrode type | Conversion efficiency |
|---|---|---|---|---|---|
| Ex. 1 | single crystal Si | Ge | Ag | nano-mesh | 13.50% |
| Ex. 2 | single crystal Si | Ge | Au | nano-mesh | 13.20% |
| Ex. 3 | single crystal Si | GeSn | Ag | nano-mesh | 14.00% |
| Ex. 4 | single crystal Si | GaSb | Cu | nano-mesh | 13.00% |
| Ex. 5 | single crystal Si | PbS | Au | nano-mesh | 12.20% |
| Ex. 6 | single crystal Si | PbSe | Cu | nano-mesh | 12.50% |
| Ex. 7 | single crystal Si | InSb | Ag | nano-mesh | 11.80% |
| Ex. 8 | single crystal Si (thin thickness) | Ge | Ag | nano-mesh | 13.00% |
| Ex. 9 | single crystal Si | Ge | Ag | metal dots | 13.30% |
| Ex. 10 | single crystal Si | GeSn | Au | metal dots | 13.00% |
| Ex. 11 | single crystal Si | GaSb | Cu | metal dots | 12.00% |
| Ex. 12 | polycrystal Si | Ge | Ag | nano-mesh | 11.10% |
| Ex. 13 | polycrystal Si | Ge | Ag | metal dots | 10.90% |

### (Example 1)

The process of producing a photoelectric conversion element in Example 1 is explained by referring to Figures 11 to 13, which are schematic sectional views illustrating the process of producing an element according to the embodiment.

First, as shown in Figure 11A, a p-type single crystal Si substrate having a thickness of 500 µm and a doping concentration of 1 x 10¹⁶ cm⁻³ was prepared. The front and back surfaces of the substrate were then subjected to ion implantation with P and B ions, respectively. After the ion implantation, activation annealing was carried out to form an n+ layer of 1 x 10²⁰-cm⁻³ concentration within 200 nm from the Si front surface and a P+ layer of 1 x 10²⁰-cm⁻³ concentration within 200 nm from the Si back surface.

Next, as shown in Figure 11B, the above was followed by forming an n-Ge layer of 1000-nm thickness according to the CVD method. During the formation of the layer, the doping concentration was so controlled that the concentration might be 10¹⁹ cm⁻³ within 100 nm from the interface with the Si surface but might be 10¹⁷ cm⁻³ in the farther range.

Subsequently, the procedure was further followed by forming an Ag layer of 30-nm thickness on the n-Ge surface according to vapor deposition, as shown in Figure 11C.

Then, as shown in Figure 12A, the Ag layer thus formed on the n-Ge surface was spin-coated at 2000 rpm for 30 seconds with a solution of resist (THMR IP3250 [trademark], manufactured by Tokyo Ohka Kogyou Co., Ltd.) diluted with ethyl lactate (EL) by 1:2, and thereafter heated on a hot plate at 110°C for 90 seconds to evaporate the solvent. The obtained resist layer had a thickness of 150 nm.

After that, as shown in Figure 12B, a quartz stamper provided with a relief pattern of 200-nm pitch, 100-nm size and 150-nm height (the pattern was formed in an area of 9 cm²) was prepared and used to conduct imprinting procedure in which, while the p-type single crystal Si substrate 30 was being heated at 120°C, the relief surface of the stamper was impressed onto the resist layer with a pressure of 10 MPa.

After the imprinting procedure, the substrate was cooled to room temperature and then the stamper was released to form an intaglio pattern of 200-nm pitch, 100-nm size and 150-nm depth on the resist layer, as shown in Figure 12C.

Subsequently, the intaglio resist pattern was etched for 30 seconds under the conditions of CF₄: 30 sccm, 10 mTorr and RF power: 100 W, as shown in Figure 12D. After the CF₄RIE, the bottom of the resist was removed to bare the Ag layer.

The Ag layer was then etched for 80 seconds by use of an ion milling apparatus under the conditions of acceleration voltage: 500 V and ion current: 40 mA, to form a nano-mesh electrode provided with openings, as shown in Figure 12E. Thus, a pattern having openings of 200-nm pitch and 100-nm size was formed on the Ag layer 5 by ion milling. The residual resist was removed with an organic solvent.

Thereafter, as shown in Figure 13A, the nano-mesh electrode was spin-coated at 2000 rpm for 30 seconds with a solution of resist (THMR IP3250 [trademark], manufactured by Tokyo Ohka Kogyou Co., Ltd.), and then heated on a hot plate at 110°C for 90 seconds to evaporate the solvent. The obtained resist layer had a thickness of 1 µm. Subsequently, the resist layer was subjected to photolithographic patterning through a grid pattern mask of 100-µm width and 1-mm interval, to form a grid pattern of 100-µm width and 1-mm interval.

The formed resist pattern was used as a mask to etch and partly remove the metal nano-mesh electrode by ion-milling for 80 seconds under the conditions of acceleration voltage: 500 V and ion current: 40 mA. Successively, the n-Ge layer was subjected to CF₄RIE for 10 minutes under the conditions of CF₄: 30 sccm, 10 mTorr and RF power: 100 W to bare the p+Si layer, as shown in Figure 13B. The residual resist was then removed.

On the bared part of the p+Si layer, a back electrode was formed by the lift-off method, as shown in Figure 13C.

Finally, as shown in Figure 13D, an interdigitated electrode was formed on the n+ layer by a screen printing method from epoxy thermosetting Ag paste, to produce a Si photoelectric conversion element comprising the n-Ge layer and the nano-mesh electrode.

### (Properties of solar cell)

The above produced photoelectric conversion element was exposed to pseudo-sunlight of AM 1.5, to evaluate the photoelectric conversion efficiency at room temperature. As a result, the single crystal Si conversion element, which comprised the n-Ge layer and the nano-mesh electrode, showed as good a photoelectric conversion efficiency as 13.5%. In contrast, a conventional single crystal Si conversion element, which did not comprise an n-Ge layer and a nano-mesh electrode, showed a photoelectric conversion efficiency of 10.0%.

Further, spectral sensitivity characteristics were also evaluated. As a result, the conventional single crystal Si conversion element was found to absorb light in the wavelength range of no longer than about 1100 nm, but the single crystal Si element comprising the n-Ge layer and the nano-mesh electrode showed an absorption spectrum even in the range of 1100 nm to 1500 nm although the intensity of spectral sensitivity was not strong in that range.

The above results indicate that the n-Ge layer and the nano-mesh electrode induced light absorption in the long wavelength range and thereby improved the photoelectric conversion efficiency.

### (Example 2)

The procedures of Example 1 were repeated except for "forming an Au layer of 30-nm thickness on the n-Ge surface according to vapor deposition" in place of "forming an Ag layer of 30-nm thickness on the n-Ge surface according to vapor deposition", to produce a Si photoelectric conversion element.

Subsequently, the photoelectric conversion efficiency was measured in the same manner as in Example 1, and the result was shown in Table 1.

### (Example 3)

The procedures of Example 1 were repeated except for "forming an n-GeSn layer of 300-nm thickness according to vapor deposition" in place of "forming an n-Ge layer of 1000-nm thickness according to the CVD method", to produce a Si photoelectric conversion element.

Subsequently, the photoelectric conversion efficiency was measured in the same manner as in Example 1, and the result was shown in Table 1.

### (Example 4)

The procedures of Example 1 were repeated except for "forming an n-GaSb layer of 200-nm thickness according to vapor deposition" and "forming a Cu layer of 30-nm thickness on the n-GaSb surface according to vapor deposition" in place of "forming an n-Ge layer of 1000-nm thickness according to the CVD method" and "forming an Ag layer of 30-nm thickness on the n-Ge surface according to vapor deposition", respectively, to produce a Si photoelectric conversion element.

Subsequently, the photoelectric conversion efficiency was measured in the same manner as in Example 1, and the result was shown in Table 1.

### (Example 5)

The procedures of Example 1 were repeated except for "forming an n-PbS layer of 500-nm thickness according to vapor deposition" and "forming an Au layer of 30-nm thickness on the n-PbS surface according to vapor deposition" in place of "forming an n-Ge layer of 1000-nm thickness according to the CVD method" and "forming an Ag layer of 30-nm thickness on the n-Ge surface according to vapor deposition", respectively, to produce a Si photoelectric conversion element.

Subsequently, the photoelectric conversion efficiency was measured in the same manner as in Example 1, and the result was shown in Table 1.

### (Example 6)

The procedures of Example 1 were repeated except for "forming an n-PbSe layer of 200-nm thickness according to vapor deposition" and "forming a Cu layer of 30-nm thickness on the n-PbSe surface according to vapor deposition" in place of "forming an n-Ge layer of 1000-nm thickness according to the CVD method" and "forming an Ag layer of 30-nm thickness on the n-Ge surface according to vapor deposition", respectively, to produce a Si photoelectric conversion element.

Subsequently, the photoelectric conversion efficiency was measured in the same manner as in Example 1, and the result was shown in Table 1.

### (Example 7)

The procedures of Example 1 were repeated except for "forming an n-InSb layer of 200-nm thickness according to vapor deposition" in place of "forming an n-Ge layer of 1000-nm thickness according to the CVD method", to produce a Si photoelectric conversion element.

Subsequently, the photoelectric conversion efficiency was measured in the same manner as in Example 1, and the result was shown in Table 1.

### (Example 8)

The procedures of Example 1 were repeated except for adopting a thin single crystal Si substrate described below in place of using the single crystal Si substrate of Example 1, to produce a Si photoelectric conversion element.

Subsequently, the photoelectric conversion efficiency was measured in the same manner as in Example 1, and the result was shown in Table 1.

Thin single crystal Si substrate: single crystal Si substrate of 50-µm thickness.

### (Example 9)

The procedures of Example 1 were repeated except for adopting a metal dot electrode formed in the following manner in place of adopting the nano-mesh electrode of Example 1, to produce a Si photoelectric conversion element.

Subsequently, the photoelectric conversion efficiency was measured in the same manner as in Example 1, and the result was shown in Table 1.

Metal dot electrode: In the same manner as in Example 1, an Ag layer was formed. Then, as shown in Figure 13, the Ag layer thus formed on the p-type single crystal Si substrate surface was spin-coated at 2000 rpm for 30 seconds with a solution of resist (THMR IP3250 [trademark], manufactured by Tokyo Ohka Kogyou Co., Ltd.) diluted with ethyl lactate (EL) by 1:2, and thereafter heated on a hot plate at 110°C for 90 seconds to evaporate the solvent. The obtained resist layer 36 had a thickness of 150 nm. After that, as shown in Figure 13B, a quartz stamper provided with an relief pattern of 150-nm size and 100-nm height (the pattern was formed in an area of 9 cm²) was prepared and used to conduct imprinting procedure in which, while the p-type single crystal Si substrate provided with the resist layer was being heated at 120°C, the relief surface of the stamper was impressed onto the resist layer with a pressure of 10 MPa. After the imprinting procedure, the substrate was cooled to room temperature and then the stamper was released to form an intaglio pattern of 150-nm size and 80-nm depth on the resist layer, as shown in Figure 13C. Subsequently, the intaglio resist pattern was etched for 30 seconds under the conditions of CF₄: 30 sccm, 10 mTorr and RF power: 100 W, as shown in Figure 13D. After the CF₄RIE, the resist bottom was removed to bare the Ag layer. The Ag layer was then etched for 80 seconds by use of an ion milling apparatus under the conditions of acceleration voltage: 500 V and ion current: 40 mA, to form metal dots on the p-Si layer, as shown in Figure 13E. Thus, a dotted pattern of 150-nm size was formed on the Ag layer by ion milling. The residual resist was removed with an organic solvent to form an electrode of metal dots.

### (Example 10)

The procedures of Example 1 were repeated except for "forming an n-GeSn layer of 300-nm thickness according to vapor deposition", "forming an Au layer of 30-nm thickness on the n-GeSn surface according to vapor deposition" and adopting a metal dot electrode formed in Example 9 in place of "forming an n-Ge layer of 1000-nm thickness according to the CVD method", "forming an Ag layer of 30-nm thickness on the n-Ge surface according to vapor deposition" and adopting the nano-mesh electrode, respectively, to produce a Si photoelectric conversion element.

Subsequently, the photoelectric conversion efficiency was measured in the same manner as in Example 1, and the result was shown in Table 1.

### (Example 11)

The procedures of Example 1 were repeated except for "forming an n-GaSb layer of 200-nm thickness according to vapor deposition", "forming a Cu layer of 30-nm thickness on the n-GaSb surface according to vapor deposition" and adopting the metal dot electrode formed in Example 9 in place of "forming an n-Ge layer of 1000-nm thickness according to the CVD method", "forming an Ag layer of 30-nm thickness on the n-Ge surface according to vapor deposition" and adopting the nano-mesh electrode, respectively, to produce a Si photoelectric conversion element.

Subsequently, the photoelectric conversion efficiency was measured in the same manner as in Example 1, and the result was shown in Table 1.

### (Example 12)

The procedures of Example 1 were repeated except for adopting a polycrystal Si substrate and "forming an n-Ge layer of 200-nm thickness according to the CVD method" in place of adopting the single crystal Si substrate of Example 1 and "forming an n-Ge layer of 1000-nm thickness according to the CVD method", respectively, to produce a Si photoelectric conversion element.

Subsequently, the photoelectric conversion efficiency was measured in the same manner as in Example 1, and the result was shown in Table 1.

### (Example 13)

The procedures of Example 1 were repeated except for adopting a polycrystal Si substrate, "forming an n-Ge layer of 300-nm thickness according to the CVD method" and adopting the metal dot electrode formed in Example 9 in place of adopting the single crystal Si substrate of Example 1, "forming an n-Ge layer of 1000-nm thickness according to the CVD method", and adopting the nano-mesh electrode, respectively, to produce a Si photoelectric conversion element.

Subsequently, the photoelectric conversion efficiency was measured in the same manner as in Example 1, and the result was shown in Table 1.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the invention.

## Claims

1. A photoelectric conversion element comprising a photoelectric conversion layer laminated a first metal layer, a first semiconductor layer, a second semiconductor layer and a second metal layer; wherein
said first or second metal layer contains a porous metal thin film,
said porous metal thin film has plural openings penetrating through said porous metal thin film,
each of said openings has an area of 80 nm² to 0.8 µm² inclusive on average,
said porous metal thin film has a thickness of 2 nm to 200 nm inclusive,
said second semiconductor layer has a smaller band gap than said first semiconductor layer,
said second semiconductor layer has polarity opposite to that of said first semiconductor layer, and
said second semiconductor layer is positioned within 5 nm from said porous metal thin film.

2. The element according to claim 1, wherein said first or second metal layer is made of a material selected from the group consisting of Al, Ag, Au, Cu, Pt, Ni, Co, Cr and Ti.

3. The element according to claim 1 or 2, wherein at least one semiconductor layer has a carrier concentration of 10¹⁹ cm⁻³ to 10²² cm⁻³ inclusive near the interface between said first and second semiconductor layers.

4. The element according to one of claims 1 to 3, wherein said second semiconductor layer is made of a material selected from the group consisting of Ge, GeSn, GaSb, PbS, PbSe and InSb.

5. The element according to one of claims 1 to 4, wherein said second semiconductor layer has a thickness of 10 nm to 1000 nm inclusive.

6. The element according to one of claims 1 to 5, wherein said first semiconductor layer contains a p- or n-type layer and said semiconductor layer is made of single crystal silicon, polycrystal silicon or amorphous silicon.

7. The element according to one of claims 1 to 5, wherein said semiconductor layer contains a p- or n-type layer and said first semiconductor layer is made of compound semiconductor.

8. A photoelectric conversion element comprising a photoelectric conversion layer laminated a first metal layer, a first semiconductor layer, a second semiconductor layer and a second metal layer; wherein
a layer containing plural minute metal particles is provided on said semiconductor layers,
each of said minute particles has a volume of 4 nm³ to 0.52 µm³ inclusive on average,
the interval between adjacent two of said minute particles is 1 nm or more if the particle volume is less than 4 x 10⁻³ µm³, but is 100 nm to 1 µm inclusive if the particle volume is 4 x 10⁻³ µm³ or more,
said second semiconductor layer has a smaller band gap than said first semiconductor layer,
said second semiconductor layer has polarity opposite to that of said first semiconductor layer, and
said second semiconductor layer is positioned within 5 nm from said minute particles.

9. The element according to claim 8, wherein said first or second metal layer is made of a material selected from the group consisting of Al, Ag, Au, Cu, Pt, Ni, Co, Cr and Ti.

10. The element according to claim 8 or 9, wherein at least one semiconductor layer has a concentration of 10¹⁹ cm⁻³ to 10²² cm⁻³ inclusive near the interface between said first and second semiconductor layers.

11. The element according to one of claims 8 to 10, wherein said second semiconductor layer is made of a material selected from the group consisting of Ge, GeSn, GaSb, PbS, PbSe and InSb.

12. The element according to one of claims 8 to 11, wherein said second semiconductor layer has a thickness of 10 nm to 1000 nm inclusive.

13. The element according to one of claims 8 to 12, wherein said first semiconductor layer contains a p- or n-type layer and said semiconductor layer is made of single crystal silicon, polycrystal silicon or amorphous silicon.

14. The element according to one of claims 8 to 12, wherein said semiconductor layer contains a p- or n-type layer and said first semiconductor layer is made of compound semiconductor.
